Europäisches Patentamt

(19) European Patent Office

Office européen des brevets

(11) Publication number: **0 231 656**

**B1**

(12) **EUROPEAN PATENT SPECIFICATION**

(45) Date of publication of the patent specification:
21.03.90

(21) Application number: 86310129.1

(22) Date of filing: 24.12.86

(51) Int. Cl.⁵: **H 01 L 29/267,** H 01 L 29/72,
H 01 L 29/86

(54) Silicon semiconductor device.

(30) Priority: 08.01.86 JP 548/86

(43) Date of publication of application:
12.08.87 Bulletin 87/33

(45) Publication of the grant of the patent:
21.03.90 Bulletin 90/12

(84) Designated Contracting States:
DE FR GB

(56) References cited:
US-A-4 254 429

EXTENDED ABSTRACTS OF THE 17TH CONFERENCE
ON SOLID STATE DEVICES AND MATERIALS, Tokyo,
25th-27th August 1985, pages 385-388, The Japan
Society of Applied Physics, JP; K. SASAKI et al.: "A
new Si bipolar transistor using amorphous SiC:H as
a wide-gap emitter"

(73) Proprietor: HITACHI, LTD.
6, Kanda Surugadai 4-chome
Chiyoda-ku Tokyo 101 (JP)

(72) Inventor: Saitoh, Tadashi
1-8-52, Sakae-cho Hamura-maci
Nishitama-gun Tokyo (JP)
Inventor: Miyazaki, Takao
881-1, Narahara-cho
Hachioji-shih Tokyo (JP)
Inventor: Kokunai, Shigeru
3-11-17, Daihara-cho
Hitachi-shi Ibaraki-ken (JP)

(74) Representative: Calderbank, Thomas Roger
MEWBURN ELLIS & CO. 2/3 Cursitor Street
London EC4A 1BQ (GB)

EP 0 231 656 B1

Note: Within nine months from the publication of the mention of the grant of the European patent, any person may give notice to
the European Patent Office of opposition to the European patent granted. Notice of opposition shall be filed in a written reasoned
statement. It shall not be deemed to have been filed until the opposition fee has been paid (Art. 99(1) European patent convension).

## Description

The present invention relates to a semiconductor device of silicon having at least one semiconductor junction.

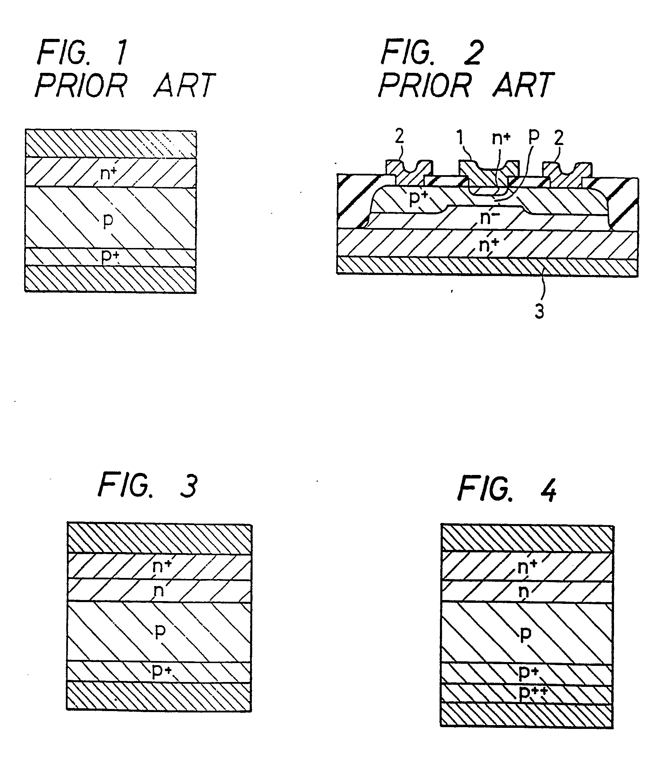

Silicon semiconductor devices of this type include rectifiers, switching devices, power devices, integrated logic and memory devices, etc., the fundamental structure of which is a diode or a transistor as shown in Fig. 1 or Fig. 2 of the accompanying drawings. Fig. 1 illustrates an $n^+/p/^+$ type diode structure, and Fig. 2 an n-p-n type bipolar transistor structure with an emitter electrode 1, a base electrode 2, and a collector electrode 3.

Improvements in the performance of such semiconductor devices, and in particular improvements in the cutoff frequency ($f_T$) and the current gain ($h_{FE}$), have been achieved by advances in microfabrication technology, but these appear to be approaching a limit. In particular, the cutoff frequency of a bipolar transistor depends on e.g. the emitter depletion layer-charging time, the base layer-charging time, the collector depletion layer-transit time, and the collector charging time. Of these, the most influential is the emitter depletion layer-charging time, at least in recently developed fine pattern transistors.

In order to enhance performance of these devices, it has been proposed to use a heterojunction structure in which an emitter of the device is made of amorphous silicon carbide (see e.g. the article by K. Sasaki et al: in "Extended Abstracts of the 17th Conference on Solid State Devices and Materials", Tokyo 1985, pp. 385 - 388, No. B-4-4). In this structure, a heterojunction acts as a barrier to holes, and the current gain ($h_{FE}$) reaches a value of approximately 50. However, this device has the problem that the $h_{FE}$ value is small, compared with the value of at least 200 in bipolar transistors presently in practical use. The inventors of the present invention believe that this problem is principally attributable to the existence of defects (boundary levels or traps) at the interface of amorphous silicon carbide and crystal silicon and the high resistivity ($10^2$ to $10^4$ $\Omega$.cm) of the amorphous silicon carbide.

The present invention seeks to overcome this problem by providing a silicon semiconductor device having a silicon body with at least one junction between two semiconductor regions of the body, the semiconductor regions being of different conductivity types, electrodes for applying current to at least part of the semiconductor regions, and a further semiconductor region on at least one of the regions opposite to the junction, the further semiconductor region forming a heterojunction with the adjacent semiconductor region, and having a band gap which is larger than that of the regions
wherein:
the further region is of the same conductivity type as the adjacent region. The further region may be of a semiconductor whose principle components are silicon and carbon. In this way it has been found possible to provide a device with high cutoff frequency and high current gain.

For example a semiconductor device may be provided in which, as shown in Fig. 3 or Fig. 4 of the accompanying drawings, an $n^+$ or $p^{++}$ layer is in contact with the n-p junction or p-p$^+$ junction of a p-n junction body or n-p-p$^+$ junction body made of silicon. Thus an n+-n or p$^+$-p$^{++}$ heterojunction is formed. The n-p junction or p-p$^+$ junction may well be a part of a body including p-n-p junctions.

The $n^+$ or $p^{+\cdots}$ semiconductor is preferably an $Si_xC_{l-x}$ semiconductor layer. With such a layer, the magnitude of the bandgap can be controlled by changing the value $x$.

The $Si_xC_{l-x}$ semiconductor layer (where $0 < x < 1.0$) may be crystalline (a single crystal or polycrystal), amorphous or a mixture consisting of the crystalline and amorphous substances. It is desirable, however, that the semiconductor layer has a sheet resistance close to that of the polycrystalline silicon material of an emitter (several tens - several hundred $\Omega/\square$). For this purpose, it is better to use a crystallized $Si_xC_{l-x}$ semiconductor. The resistance of the crystallized $Si_xC_{l-x}$ semiconductor can be lowered by suitable selection of the conditions under which the film is formed or an amorphous film is heat treated (by way of example, a value of $10^{-1}$ $\Omega$.cm is attained by annealing for a short time using an excimer laser or a lamp).

The $Si_xC_{l-x}$ semiconductor layer may be formed e.g. by plasma chemical vapour deposition (CVD), sputtering, thermal CVD, or molecular beam epitaxy.

When the $Si_xC_{l-x}$ semiconductor layer is hydrogenated, defects in this $Si_xC_{l-x}$ semiconductor layer and defects at the hetero-interface of the $Si_xC_{l-x}$ layer and the Si layer can be rendered electrically inactive. Such an $Si_xC_{l-x}$ semiconductor layer ($0 < x < 1.0$) can be formed by plasma CVD of $SiH_4$-$CH_4$ reactant gases or the hydrogenation (such as processing in a plasma or hydrogen ion implantation) of the crystallized $Si_xC_{l-x}$ semiconductor layer formed at a comparatively high temperature.

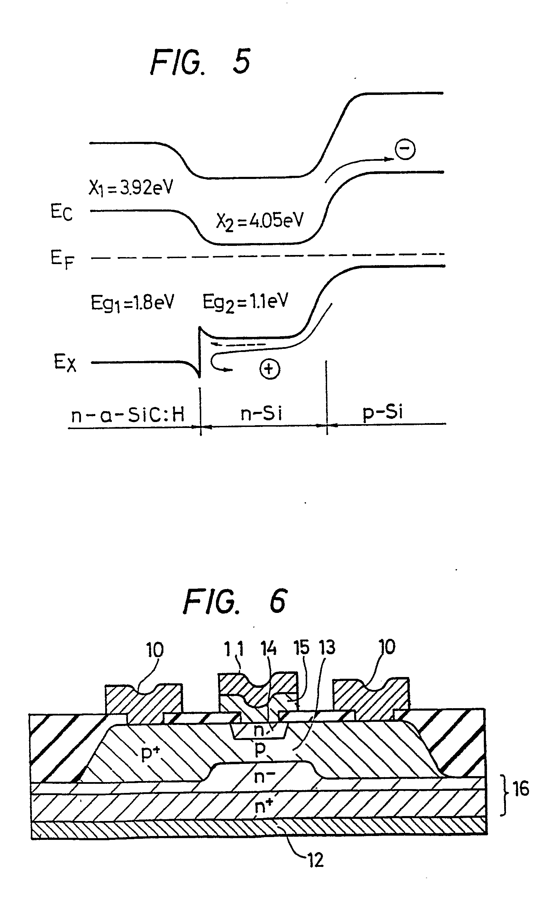

The features of the heterojunction operation between an $Si_xC_{l-x}$ semiconductor film and a crystal silicon film will be described with reference to Fig. 5 of the accompanying drawings.

Minority carriers $\ominus$ shown in Fig. 5 are recombined at the front surface of p-Si as indicated by a solid arrow, and in the absence of a-SiC:H, minority carriers $\oplus$ are recombined at the front surface of n-Si as indicated by a dotted arrow. Thus the current gain is reduced. Therefore, an n-type amorphous SiC:H film is formed on the n-Si surface. Then, the band structure of the hetero-junction between this n-type amorphous $Si_xC_{l-x}$:H film and the n-type crystal Si film is as illustrated in Fig. 5. Since the electron affinity ($X_l$) of the amorphous SiC:H film is 3.92 eV and is close to the electron affinity ($X_2$) of the crystal Si film which is 4.05 eV, a barrier for holes is formed at the interface of the heterojunction. By making the n-type Si film sufficiently thin to permit the minority car- minority carriers to diffuse (by way of example, several hundredths of the diffusion length is desirable, giving a thickness of several to several hundred nanometres in practice), the holes (⊕) are reflected by the barrier as indicated by the solid arrow, and the injection of the holes into the n-type Si emitter layer is prevented. This results in a sharp increase in the current gain of the transistor.

Similarly, when a thin SiC film is formed on the p-Si side, the electrons ⊖ behave in a similar way. The structure shown in Fig. 4 corresponds to the case where thin SiC films are formed on both the n- and p-sides.

Although boundary levels usually exist at the interface of the heterojunction, the interposition of a thin n-type Si layer separates the heterojunction interface and the n-p junction interface, so that the influence of the boundary levels of the heterojunction can be significantly reduced. In addition, carrier concentration of the n-type layer may be reduced and the layer itself can be thin, so that the time constant between the emitter and the base can be reduced. Furthermore, the carrier concentration of the base may increase, by increase in $h_{FE}'$ with the result that the cutoff frequency of the transistor can be raised.

Thus, according to the present invention, a transistor of high cutoff frequency and high current gain can be readily provided, which permits enhancement of the performances of various electronic devices, and reducing their sizes.

Moreover, the $Si_xC_{1-x}$ semiconductor layer has a lower reactivity with an Al electrode when compared with an Si electrode so that it becomes possible to use a thinner layer.

Embodiments of the invention will now be described, by way of example, with reference to the accompanying drawings, in which:

— Figs. 1 and 2 are cross-sectional views for explaining prior art devices, and have already been discussed;
— Figs. 3 and 4 are cross-sectional views showing the fundamental construction of a device according to the present invention, and have already been discussed;
— Fig. 5 is a band structure diagram for explaining the principle of operation of a device according to the present invention, and has already been discussed;
— Fig. 6 is a cross-sectional view of a device which illustrates embodiments of the present invention.

## Example 1

An example of an application of the present invention to a transistor element will now be described with reference to Fig. 6.

In Fig. 6 there is shown a base electrode 10, an emitter electrode 11 and a collector electrode 12, respectively. A p-type base portion 13 and an $n^-$-$n^+$-type collector portion 16 were made within an Si substrate by ion implantation and annealing, by known methods. The thickness of an n-type emitter region 14 was 3 to 100 nm and molecular beam epitaxy was used for forming this thin layer. An amorphous n-type SiC:H (silicon carbide containing hydrogen) layer 15 was formed on the region 14 to form an n-n-type heterojunction.

Plasma CVD was used to form the amorphous SiC:H layer 15. In this method a plasma reaction is carried out with mixed gases of $SiH_4$-$CH_4$ by applying a high-frequency field of 13 MHz under a low pressure of several hundred pascals. When the mol ratio of the mixed gases is set to be 4 : 1, an SiC:H layer is formed in which the ratio of Si and C is substantially 4 : 1. When forming the n-type SiC:H layer, $PH_3$ (500 ppm in $H_2$) is included in the reactant gases, and when forming a p-type SiC:H layer, $B_2H_6$ (1080 ppm in $H_2$) is included in the reactant gases. The temperature of the substrate was set at 200° to 400°C. The resistivity of the n-type SiC:H film obtained was $10^2$ Ω.cm. A thickness of several to several tens of nanometres was found to be sufficient to attain the effects of the heterojunction. The current gain of the heterojunction transistor produced was about 1 000.

## Example 2

This example discusses the formation of a microcrystal SiC layer of lower resistivity, replacing the amorphous SiC:H layer in Example 1.

To form the microcrystal SiC layer, plasma CVD of mixed gases $SiH_4$-$CH_4$-$H_2$ was used. $PH_3$ is included to form an n-type layer, and $B_2H_6$ to form a p-type layer. $H_2$ was added into the reactant gases for the purpose of microcrystallization. The resistivity of the film obtained was 1 to 100 Ω.cm, and a transistor of low series resistance could thus be fabricated.

## Example 3

In this example, a crystallized SiC layer of lower resistivity was used, instead of the amorphous SiC:H layer in Example 1.

In order to form the crystallized SiC layer, an amorphous SiC:H layer was first formed by the method described in Example 1. This amorphous SiC layer was irradiated by a pulsed excimer laser so as to crystallize the film. The laser irradiation had a pulse width of 20 ns and a laser output energy density of 0.2 J/cm². The resistivity of the film obtained depended upon the intensity of the laser. The resistivity achievable with uniformity of the laser-irradiated film was in a range of values 1 to $10^{-1}$ Ω.cm, and a transistor of high performance could thus be fabricated.

With this method, an n-type amorphous SiC:H layer is provided directly on a p-type base layer, and an n-type emitter layer the n-type SiC layer is diffused into the base layer by the laser annealing, so that an n-type Si emitter layer can be formed. This method is particularly effective when forming a thin n-type emitter layer.

## Example 4

This example discusses the formation of a single-crystal SiC layer of lower resistivity replacing the amorphous SiC:H layer in Example 1.

A pyrolytic epitaxial method employing mixed gases of $SiH_4$-$CH_4$ was used to form an n-type SiC single-crystal layer on an n-type Si single-crystal layer. To achieve this, a single-crystal Si substrate was heated to 1 000 to 1 100°C, and $PH_3$ gas was added so as to form the n-type SiC single-crystal layer. An oxide film was provided on the n-type Si single-crystal layer and was thereafter volatilized by a high-temperature treatment, to obtain a clean Si surface on which an SiC layer of good quality could be formed.

Although the above examples were applied to an n-p-n transistor structure, results obtained with a p-n-p transistor structure were similarly favourable.

## Example 5

In each of Examples 3 and 4, the n-type crystallized SiC layer was formed on an n-p-n transistor structure. Thereafter, the SiC layer was hydrogenated. Methods for hydrogenation include annealing in $H_2$, treatment in an H plasma, and implantation of H ions. With any of these methods, the defects of the SiC layer and SiC/Si interface could be rendered electrically inactive.

## Example 6

In the foregoing examples, the value $x$ of the $Si_xC_{1-x}$ semiconductor layer was varied to form the heterojunction.

The graded composition can readily be achieved by changing the gaseous ratio of, e.g. $SiH_4$/$CH_4$ during the formation of the semiconductor. With this graded composition, electrical defects at the $Si_xC_{1-x}$ semiconductor layer or the $Si_xC_{1-x}$/Si interface could be reduced thus enhancing the performance of the transistor.

Although the present invention has been described as to the case of employing the $Si_xC_{1-x}$ semiconductor layer, other semiconductors of high bandgap (for example GaAs) may also be used.

## Claims

1. A silicon semiconductor device having a silicon body with at least one junction between two semiconductor regions (13, 14) of the body, the semiconductor regions (13, 14) being of different conductivity types, electrodes (10, 11, 12) for applying current to at least part of the semiconductor regions (13, 14), and a further semiconductor region (15) on at least one of the regions (13, 14) opposite to the junction, the further semiconductor region (15) forming a heterojunction with the adjacent semiconductor region (14), and having a band gap which is larger than that of the regions (13, 14) *characterised in that:* the further region (15) is of the same conductivity type as the adjacent region (14).

2. A device according to claim 1, wherein the further region (15) is of a semiconductor whose principal components are silicon and carbon.

3. A device according to claim 1 or claim 2, wherein a composition of the further semiconductor region (15) varies continuously with increasing distance from the one semiconductor region (14).

4. A device according to any one of claims 1 to 3, wherein the further semiconductor region (15) is 3 to 100 nm thick.

5. A device according to any one of the preceding claims, wherein the device is a transistor or a diode.

6. A device according to any one of the preceding claims, wherein the further semiconductor region (15) is of hydrogenated crystal SiC, hydrogenated amorphous SiC, or a mixture of these.

7. A device according to claim 6, wherein the SiC has a resistivity of 1 - 100 Ω.cm.

8. A device according to any one of the preceding claims, wherein the further semiconductor region (15) is of p-type or n-type semiconductor.

9. A device according to any one of the preceding claims having another semiconductor region (16), thereby to form a bipolar transistor, the collector of the transistor being formed by the another semiconductor region (16), the base being formed by one of the regions (13), and the emitter being formed by the other one of the regions (14) and the further region (15).

## Patentansprüche

1. Silicium-Halbleitereinrichtung mit einem Siliciumkörper, der mindestens einen Übergang zwischen zwei Halbleiterbereichen (13, 14) des Körpers aufweist, wobei die Halbleiterbereiche (13, 14) unterschiedliche Leitfähigkeitstypen aufweisen, Elektroden (10, 11, 12) zum Anlegen von Strom an mindestens einen Teil der Halbleiterbereiche (13, 14), und einem weiteren Halbleiterbereich (15), der auf mindestens einem der Bereiche (13, 14) auf der von dem Übergang abgewandten Seite angeordnet ist, mit dem benachbarten Halbleiterbereich (14) einen Hetero-Übergang bildet und einen größeren Bandabstand hat als die Bereiche (13, 14), *dadurch gekennzeichnet*, daß der weitere Bereich (15) den gleichen Leitfähigkeitstyp hat wie der benachbarte Bereich (14).

2. Einrichtung nach Anspruch 1, wobei der weitere Bereich (15) aus einem Halbleiter besteht, dessen Hauptbestandteile Silicium und Kohlenstoff sind.

3. Einrichtung nach Anspruch 1 oder 2, wobei sich die Zusammensetzung des weiteren Halbleiterbereichs (15) mit zunehmendem Abstand von dem einen Halbleiterbereich (14) kontinuierlich ändert.

4. Einrichtung nach einem der Ansprüche 1 bis 3, wobei der weitere Halbleiterbereich (15) 3 bis 100 nm dick ist.

5. Einrichtung nach einem der vorhergehenden Ansprüche, wobei die Einrichtung ein Transistor oder eine Diode ist.

6. Einrichtung nach einem der vorhergehenden Ansprüche, wobei der weitere Halbleiterbereich (15) aus hydriertem kristallinen SiC, hydriertem amorphem SiC oder einem Gemisch daraus besteht.

7. Einrichtung nach Anspruch 6, wobei das SiC einen spezifischen Widerstand von 1 bis 100 Ωcm hat.

8. Einrichtung nach einem der vorhergehenden Ansprüche. wobei der weitere Halbleiterbereich (15) ein solcher des P- oder des N-Typs ist.

9. Einrichtung nach einem der vorhergehenden Ansprüche mit einem zusätzlichen Halbleiterbereich (16) zur Bildung eines Bipolar-Transistors, wobei der Kollektor des Transistors von dem zusätzlichen Halbleiterbereich (16), die Basis von einem (13) der Bereiche und der Emitter von dem anderen (14) der Bereich und dem weiteren Bereich (15) gebildet ist.

**Revendications**

1. Dispositif à semiconducteurs en silicium comportant un corps en silicium possédant au moins une jonction située entre deux régions semiconductrices (13, 14) du corps, les régions semiconductrices (13, 14) possédant des types de conductivité différents, des électrodes (10, 11, 12) servant à appliquer un courant au moins à une partie des régions semiconductrices (13, 14), et une région semiconductrice supplémentaire (15) située sur au moins l'une des régions (13, 14) à l'opposé de la jonction, la région semiconductrice supplémentaire (15) formant une hétérojonction avec la région semiconductrice adjacente (14), et possédant une bande interdite qui est supérieure à celle des régions (13, 14), *caractérisé en ce*

que la région supplémentaire (15) possède le même type de conductivité que la région adjacente (14).

2. Dispositif selon la revendication 1, dans lequel la région supplémentaire (15) est un semiconducteur, dont les constituants principaux sont le silicium et le carbone.

3. Dispositif selon la revendication 1 ou 2, dans lequel la composition de la région semiconductrice supplémentaire (15) varie continûment au fur et à mesure que la distance par rapport à la région semiconductrice (14) augmente.

4. Dispositif selon l'une quelconque des revendications 1 à 3, dans lequel la région semiconductrice supplémentaire (15) possède une épaisseur comprise entre 3 et 100 nm.

5. Dispositif selon l'une quelconque des revendications précédentes, dans lequel le dispositif est un transistor ou une diode.

6. Dispositif selon l'une quelconque des revendications précédentes, dans lequel la région semiconductrice supplémentaire (15) est constituée par du SiC cristallin hydrogéné, par du SiC amorphe hydrogéné ou par un mélange de ces matériaux.

7. Dispositif selon la revendication 6, dans lequel le SiC possède une résistivité égale à 1 - 100 Ω.cm.

8. Dispositif selon l'une quelconque des revendications précédentes, dans lequel la région semiconductrice supplémentaire (15) est un semiconducteur du type p ou du type n.

9. Dispositif selon l'une quelconque des revendications précédentes comportant une autre région semiconductrice (16), de manière à former un transistor bipolaire, le collecteur de ce transistor étant formé par l'autre région semiconductrice (16), sa base étant formée par l'une des régions (13), et l'émetteur étant formé par l'autre des régions (14) et la région supplémentaire (15).

EP 0 231 656 B1

FIG. 1
PRIOR ART

FIG. 2
PRIOR ART

FIG. 3

FIG. 4

## FIG. 5

$X_1 = 3.92eV$

$E_C$

$X_2 = 4.05eV$

$E_F$

$Eg_1 = 1.8eV$  $Eg_2 = 1.1eV$

$E_X$

⊖

⊕

n-a-SiC:H | n-Si | p-Si

## FIG. 6

10   11  14  15  13   10

n

p

p⁺

n⁻

n⁺

} 16

12